Europäisches Patentamt

**European Patent Office**

**Office européen des brevets**

(19)

(11)    **EP 1 154 959 B1**

(12)    **EUROPÄISCHE PATENTSCHRIFT**

(45) Veröffentlichungstag und Bekanntmachung des
Hinweises auf die Patenterteilung:
**06.10.2004   Patentblatt 2004/41**

(51) Int Cl.⁷: **C03B 23/025**, C03B 23/203,
G02B 3/00, G03B 7/00,
H02N 1/00, B81B 7/00

(21) Anmeldenummer: **00977563.6**

(22) Anmeldetag: **23.11.2000**

(86) Internationale Anmeldenummer:
**PCT/EP2000/011688**

(87) Internationale Veröffentlichungsnummer:
**WO 2001/038240 (31.05.2001 Gazette 2001/22)**

(54) **VERFAHREN ZUR HERSTELLUNG VON MIKROMECHANISCHEN UND MIKROOPTISCHEN BAUELEMENTEN AUS GLASARTIGEN MATERIALIEN**

METHOD FOR PRODUCING MICROMECHANICAL AND MICRO-OPTIC COMPONENTS CONSISTING OF GLASS-TYPE MATERIALS

PROCEDE DE PRODUCTION DE COMPOSANTS MICROMECANIQUES ET MICRO-OPTIQUES EN MATERIAU DE TYPE VERRE

(84) Benannte Vertragsstaaten:
**AT BE CH CY DE DK ES FI FR GB GR IE IT LI LU
MC NL PT SE TR**

(30) Priorität: **25.11.1999  DE 19956654**

(43) Veröffentlichungstag der Anmeldung:
**21.11.2001   Patentblatt 2001/47**

(73) Patentinhaber: **Fraunhofer-Gesellschaft zur
Förderung der angewandten Forschung e.V.
80686 München (DE)**

(72) Erfinder:
• **QUENZER, Hans-Joachim
  25524 Itzehoe (DE)**

• **MERZ, Peter
  25557 Hanerau-Hademarschen (DE)**
• **SCHULZ, Arne, Veit
  22457 Hamburg (DE)**

(74) Vertreter: **Rösler, Uwe, Dipl.-Phys. et al
Rösler Patentanwaltskanzlei,
Landsberger Strasse 480a
81241 München (DE)**

(56) Entgegenhaltungen:
**EP-A- 0 493 202          EP-A- 0 690 028
WO-A-97/19027          DE-A- 1 596 490
US-A- 3 961 929          US-A- 4 883 524
US-A- 4 883 525          US-A- 5 122 176**

## Beschreibung

### Technisches Gebiet

Die Erfindung betrifft Verfahren zur Herstellung von mikromechanischen und mikrooptischen Bauelementen und/oder Funktionselementen aus glasartigen Materialien, welches durch Ausnutzung der Fließeigenschaften des Glases die Abformung von strukturierten Substratoberflächen in Glas mit Standardverfahren der Halbleitertechnologie ermöglicht. Unter Funktionselement wird dabei ein erfindungsgemäß oberflächenstrukturiertes Substrat aus glasartigem Material verstanden, welches in weiterführenden Verfahrensschritten Verwendung findet.

Formgebungsverfahren, z.B. in einkristallinem Silizium sind in der Halbleitertechnologie, als Standardverfahren, weit verbreitet. Für transmissive mikrooptische Bauelemente wie Linsen, optische Gitter oder Strahlformer eignen sich jedoch Halbleitermaterialien nur bedingt. Silizium ist z.B. im sichtbaren Wellenlängenbereich des Lichtes stark absorbierend. So werden optische Bauelemente für Wellenlängen zwischen 380 nm und 760 nm aus glasverwandten Materialien hergestellt. Die zahlreichen vorteilhaften Materialeigenschaften des Glases, wie z.B. ein geringer thermischer Ausdehnungskoeffizient oder hohe mechanische und chemische Stabilität werden auch bei mikromechanischen Bauelementen vorteilhaft eingesetzt. Der Herstellung solcher Bauelemente sind jedoch dahingehend Grenzen gesetzt, dass hinsichtlich der Mikrostrukturierung von glasartigen Materialien nur bedingt geeignete Verfahren zur Verfügung stehen. Insbesondere fallen die Standardverfahren aus der Halbleitertechnologie aus, da für glasartigen Materialien keine geeigneten Ätzverfahren mit vergleichbaren Strukturhöhen bekannt sind.

### Stand der Technik

Für die Herstellung von mikrooptischen sowie mikromechanischen Bauelementen werden gemäß dem Stand der Technik mechanische Verfahren wie Schleifen, Sägen, Polieren und Ritzen angewandt (z.B. Echelette-Gitter). Dadurch ist jedoch sowohl die Genauigkeit als auch die Formvariation stark eingeschränkt. Das für die Massenproduktion von makroskopischen Gegenständen eingesetzte Heißprägen von Glas eignet sich nicht zur Produktion von mikrooptischen oder mikromechanischen Bauelementen im Größenbereich unter einem Millimeter, da es an geeigneten Materialien für die Herstellung der Prägeformen mangelt und das Ablösen des Glases von der Prägeform zu schlechten Oberflächenqualitäten führt. Ein Verfahren zur Herstellung von Mikrooptiken beruht auf der Erzeugung von dreidimensionalen Strukturen in Lack mit Hilfe der Grautonlithographie sowie anschließender Übertragung der Struktur in das darunter liegende Glassubstrat mit einem RIE-Plasmaprozess (US-A-5310623).

Ein weiteres Verfahren zur Herstellung von Mikrolinsen sowie Mikrolinsenarrays benutzt Lackarrays, die angeschmolzen werden und somit linsenförmige Topographien ausbilden, die darauf hin mit einem Ätzprozess in das darunter liegende Substrat übertragen werden. Beide Verfahren sind in der Bauelementhöhe auf einige zehn Mikrometer und damit auch in der lateralen Dimension beschränkt. Außerdem erhöht der Ätzprozess die Oberflächenrauhigkeit.

### Darstellung der Erfindung

Der Erfindung liegt die Aufgabe zugrunde Verfahren zur Strukturierung von Oberflächen mikromechanischer und/oder mikrooptischer Bauteile und/oder Funktionselemente aus Glas oder glasartigen Materialien anzugeben, welche die präzise und kostengünstige Formgebung der Elemente bis in den sub-µm-Bereich ermöglichen, wobei die Höhe der Elemente bis zu einigen hundert Mikrometer betragen kann sowie mit dem Verfahren hergestellte Elemente bereitzustellen.

Gemäß der vorliegenden Erfindung wird die Aufgabe durch die Verfahren der unabhängigen Ansprüche 1 bis 3 gelöst. Ein mit dem Verfahren hergestelltes Bauelement bzw. Funktionselement ist im Anspruch 22 angegeben.

Die bevorzugten Ausführungsformen sind Gegenstand der abhängigen Ansprüche.

Das erfindungsgemäße Verfahren verwendet Standardlithographie- und Ätzverfahren zur Herstellung von Negativformen (Masterstrukturen) aus einem Substrat, bevorzugt ein Halbleitersubstrat, z.B. aus Silizium. Im Folgenden wird ohne Beschränkung der Allgemeinheit von einem Halbleitersubstrat gesprochen. Durch die Kombination von Standardverbindungstechniken, bevorzugt dem anodischem Bonden mit einem Fließprozess bei erhöhter Temperatur werden die Masterstrukturen in Glas oder glasverwandte Materialien übertragen. Die Negativformen haben eine zu der gewünschten Oberflächenstruktur des Glasmaterials spiegelbildliche Oberflächenstruktur, d.h. dort wo sich auf der Oberfläche des Halbleitersubstrates Vertiefungen befinden werden im Glasmaterial auf der dem Halbleitersubstrat zugewandten Oberfläche Überhöhungen erzeugt. Die Negativformen werden bevorzugt aus einkristallinem Silizium hergestellt. Dazu stehen durch die Kombination von Lithographieprozessen mit naßchemischen isotropen sowie anisotropen Ätzverfahren und diversen Trockenätzverfahren eine große Zahl von Möglichkeiten zur Prozessierung fast beliebiger Oberflächenstrukturen zur Verfügung.

In ähnlicher Weise können optische Linsen mit einer äußerst geringen Oberflächenrauhigkeit und einer Größe unter einem Millimeter erzeugt werden. Bei geringeren Temperaturen oder kürzeren Temperzeiten senkt sich das glasartige Material langsam in die Hohlräume auf dem Substrat und bildet definierte, linsenförmige Oberflächen aus. Die Hohlräume können durch Kanalsysteme miteinander verbunden sein, um überall den selben Prozessdruck zu gewährleisten. Die Einsinktiefe, die die Brennweite einer derartig hergestellten Linse bestimmt, kann durch Temperatur, Druck und Temperzeit exakt eingestellt werden. Ein anschließender Polierschritt gleicht die auf der vom Substrat abgewandten Seite entstehenden Dellen aus, so dass nach dem Wegätzen des Substrats Mikrolinsen und Mikrolinsenarrays in beliebiger Formvariation auf dem Glas vorhanden sind.

Bevorzugt wird für das Verfahren allgemein Bor-Silikat-Glas, z.B. Pyrex®-Glas, eingesetzt. Da dieses ein geringes, der thermischen Ausdehnung von Silizium entsprechendes, thermisches Ausdehnungverhalten besitzt. Die Verbindung zwischen dem Glas und dem Halbleitersubstrat bleibt dann beim Tempern besonders stabil. Unter glasartigem Material sind jedoch alle Materialien zu verstehen, welche die günstigen Materialeigenschaften von Glas mindestens teilweise besitzen und durch Temperaturerhöhung, und/oder unter Einwirkung einer Druckdifferenz, viskose Fließeigenschaften aufweisen, wie z.B. Glaskeramiken.

Das erfindungsgemäße Verfahren besteht aus der folgenden Prozessfolge:

- Mit herkömmlichen Lithographieprozessen werden digitale oder kontinuierliche Strukturen in einen photosensitiven Lack übertragen, der auf einem Halbleitersubstrat, bevorzugt einem einkristallinem Siliziumwafer, aufgebracht ist. Mit der in der Halbleiterindustrie üblichen Kontakt- oder Projektionsbelichtung stehen Standardverfahren zur Übertragung von digitalen Strukturen zur Verfügung. Mit Hilfe der Grautonlithographie können fast beliebig geformte Oberflächen strukturiert werden. Nach dem Belichten wird in einem Entwicklerbad das nicht belichtete Lackvolumen entfernt.
- Durch Ätzprozesse wird die Topographie des Lakkes auf das Halbleitersubstrat übertragen. Dies kann sowohl durch nasschemische Ätzverfahren (z.B. Ätzen in Bädern welche Wasserstoff-Fluor-Verbindungen enthalten) als auch durch Trockenätzverfahren (Plasma Etch, Reactive Ion Etch) geschehen.
- Das strukturierte Halbleitersubstrat wird mit einem Substrat aus einem glasartigen Material (Glassubstrat), z. B. einem Pyrex®-Wafer bevorzugt mit dem anodischen Bond- Verfahren verbunden, so dass eine hermetisch dichte Verbindung zwischen dem Halbleitersubstrat und dem Glassubstrat entsteht. Dies geschieht unter Vakuum ähnlichen Bedingungen, bzw. unter Unterdruck. Nach dem Bonden ist der Druck, welcher während des Bondens in der Prozesskammer herrschte, in den Vertiefungen der Oberflächenstruktur des Halbleitersubstrats konserviert. Bei der Technik des anodischen Bondens werden zwei hochplanare Substrate auf einer sogenannten Hot Plate erhitzt, wobei es sich um jeweils ein leitendes (z.B. Halbleitersubstrat) und ein nicht leitendes Substrat (z.B. Glassubstrat) handelt. Zusätzlich wird eine Spannung von bis zu 1000 Volt zwischen den Substraten angelegt. Befindet sich der negative Pol am Glassubstrat, so wandern die in der Glasmatrix vorhandenen positiven, beweglichen Ionen (z.B. Natrium, Kalium, Bor, Schwefel) in Richtung Kathode. Die unbeweglichen, ortsfesten Sauerstoffionen bilden an der Grenze zum Halbleitersubstrat eine negative Raumladungszone. Die resultierende elektrostatische Kraft führt zu einem engen Kontakt der beiden angrenzenden Substratoberflächen. Zusammen mit der Wirkung erhöhter Temperatur führt dies zur Bildung von chemischen Bindungen zwischen den Atomen der Leiter- und Nichtleitersubstrate. Wird zusätzlich eine äußere Anpresskraft auf die Substrate ausgeübt, so führt dies zu einer Verstärkung der Bindung.

- Durch anschließendes Tempern, bevorzugt bei Normaldruck, wird das Glasmaterial über dessen Glastemperatur erhitzt. Das Glasmaterial füllt dabei, resultierend aus seinen dann plastischen Eigenschaften, die Öffnungen in der strukturierten Oberfläche des Halbleitersubstrats aus. Die Temperzeit und - temperatur muss dabei so groß sein, dass, bei den gegebenen relativen Druckverhältnissen zwischen dem Druck der Atmosphäre im Temperofen und dem, in den Vertiefungen der Halbleitersubstratoberfläche, konserviertem Druck während des Bondens, das Glasmaterial soweit in die Vertiefungen hineinfließt, dass eine Abformung der Halbleiteroberflächenstruktur erreicht wird. Die treibende Kraft gegen den viskosen Widerstand der plastischen Glasmaterialmasse bildet der in den Öffnungen vorhandene Unterdruck gegenüber der Atmosphäre im Temperofen. Bei identischer Temperatur und Prozesszeit haben die Materialeigenschaften des Glassubstrats den größten Einfluss auf die Ausprägung und Genauigkeit der Abformung. Insbesondere die genaue Zusammensetzung des Glases, wie z.B. die Dotiermenge und -art (z.B. Bor, Phosphor) beeinflussen sein viskoses Verhalten. Weiter hängt das Abformverhalten von der Qualität des Vakuums während des anodischen Bondens ab.
- Durch den Materialfluss können an der vom Halbleitersubstrat abgewandten Oberfläche des Glassubstrats Unebenheiten entstehen. Diese Unebenheiten entstehen insbesondere, wenn das Glassubstrat relativ zu den abzuformenden Strukturen auf dem Halbleitersubstrat eine geringe Dicke aufweist. Je dicker das Glassubstrat, desto geringere Unebenheiten entstehen auf der vom Halbleitersubstrat abgewandten Oberfläche des Glassubstrats. Diese werden sofern sie unerwünscht sind durch Schleif- und/oder Polierprozesse entfernt. Insofern eine Trennung des prozessierten Glassubstrats vom Halbleitersubstrat gewünscht wird, kann zur Trennung des prozessierten Glassubstrats vom Halbleitersubstrat ein Standardätzprozess verwendet werden, bei dem das Silizium komplett weggeätzt wird und die Glasmatrix erhalten bleibt. Dazu eignen sich verschiedene Chemikalien wie z.B. Tetramethylammoniumhydroxid (TMAH) oder Xenondifluorid ($XeF_2$).

In einer Prozeßvariante können refraktive Linsen und Linsenarrays durch ein teilweises Hineinfließen in eine Siliziumstruktur hergestellt werden. Dazu werden in dem Halbleiterwafer Vertiefungen nass- oder trockenchemisch hineingeätzt, welche so dimensioniert sind, dass die nach dem Tempern die Linsen bildenden Auswölbungen im Glassubstrat die Vertiefungswände nicht berühren. Beim Tempern bevorzugt bei Normaldruck des, unter Vakuum bzw. Unterdruck, mit dem Halbleitersubstrat verbundenen Glassubstrats wird dieses auf 600 bis 800 Grad Celsius aufgeheizt. Im Unterschied zu dem vorbeschriebenen Prozess wird der Vorgang des Hineinsinkens des Glassubstrats in die vorbereiteten Vertiefungen des Halbleitersubstrats durch abkühlen gestoppt, wenn der gewünschte Grad des Hineinfließens, also die gewünschte z.B. Linsenform, erreicht ist. Anschließend, nach abkühlen, kann die vom Halbleitersubstrat abgewandte Seite des Glassubstrats planiert werden und die Linsen können durch Abätzen des Halbleitersubstrats freigelegt werden.

Eine weitere Abwandlung des Prozesses ist insbesondere für die Strukturierung mikromechanischer Bauelemente interessant. Beispielsweise kann diese Variante des erfindungsgemäßen Verfahrens bei der Herstellung von gekrümmten Oberflächen für die Realisierung von effektiven elektrostatischen Aktuatoren für den Betrieb mit niedriger Spannung, wie diese z.B. für den Aufbau von Mikrorelais oder Mikroventilen benötigt werden, zum Einsatz kommen. Dazu kann in vorteilhafter Weise ausgenutzt werden, daß sich beim Hineinfließen des Glasmaterials in die Vertiefungen des Halbleitersubstrats auf der von dem Halbleitersubstrat abgewandten Oberfläche des Glassubstrats, immer sehr glatte und geschwungene Oberflächenformen ausbilden.

In Abwandlung des beschriebenen Verfahrens wird nicht die vom Halbleitersubstrat abgewandte Oberfläche des Glassubstrates nach dem Erkalten planiert, sondern für die Herstellung der mikromechanischen Bauelemente weiter verwendet. Die Oberfläche des Glassubstrates welche mit dem Halbleitersubstrat verbunden wurde kann nach wegätzen des Halbleitersubstrates planiert. Für diese Anwendungen ist das Wegätzen des Halbleitersubstrates nicht zwingend notwendig. Auf der vom Halbleitersubstrat abgewandte Oberfläche des Glassubstrates werden die weiteren Herstellungsschritte des/der mikromechanischen Bauelements/e aufgebaut.
Im Falle eines elektrostatischen Aktuators werden zunächst die Antriebselektroden in den geschwungenen Gruben des Glasmaterials hergestellt. Anschließend wird eine dünne Schicht über die Gruben mit diesen Elektroden gespannt und strukturiert. Dies kann beispielsweise durch das anodische Bonden eines Siliziumwafers (z.B. Silicon On Isolater-Wafer) auf die Oberfläche des Glases geschehen, welcher daraufhin bis auf eine dünne Schicht zurückgeschliffen und/oder geätzt wird.

Die auf die beschriebene Weise produzierten Formen in Glas oder glasartigen Materialien können als Funktionselement wiederum eine Masterstruktur für die Herstellung von Präge- und/oder Spritzgussformen, z. B. Nickelformen beim Spritzgussverfahren bilden. Dazu wird bevorzugt die durch teilweises Einfließen des Glases in die Oberflächenstruktur des Halbleitersubstrats erzeugte Glasform in einem Galvanikprozess in Metall, bevorzugt einer Nickellegierung abgeformt. Das Metall wird dabei auf der abzuformenden Oberfläche aus einer Lösung heraus abgeschieden. Die so hergestellte Metallabformung stellt, nachdem die Glasform abgelöst und/oder weggeätzt ist, die Masterform für im Präge- und/oder Spritzgussverfahren herzustellende oberflächenstrukturierte Produkte aus Materialien die für eine derartige Verwendung geeignet sind, z.B. Kunststoff, dar.

Die vorstehend beschriebenen Prozessvarianten basieren auf ein gezieltes lokales Einfließen von erweichtem glasartigem Material in die Bereiche der Vertiefungen des jeweils vorzugsweise aus einem Halbleitermaterial, bspw. Si-Wafer, bestehendem ersten Substrats. Demgegenüber sieht eine dritte Prozessvariante zur Strukturierung von Oberflächen mikromechanischer und/oder mikrooptischer Bauteile und/oder Funktionselemente aus glasartigen Materialien vor, das erste Substrat mit dem zweiten Substrat derart mindestens teilweise überdeckend zusammenzuführen, so dass ein Medium, vorzugsweise gasförmiges Medium, in das eingeschlossene Volumen der Vertiefungen eingebracht wird, das sich bei Erwärmung, d.h. beim nachfolgenden Tempervorgang, ausdehnt. Die Folge hiervon ist, dass das erweichte glasartige Material lokal im Bereich der Vertiefungen von dem in dem eingeschlossenen Volumen herrschenden Überdruck regelrecht verdrängt wird, sodass sich in der Oberfläche des zweiten Substrates, die unmittelbar den Vertiefungen gegenüberliegt, Einbuchtungen in Form von konkaven Geometrien ausbilden, die in einer praktischen Anwendungsform als optische Zerstreuungslinsen verwendbar sind.

In allen vorstehenden Prozessvarianten gilt es das erste Substrat vom zweiten Substrat nach Beendigung des formgebenden Temperschrittes und Erkalten des glasartigen zweiten Substrates bei Bedarf zu trennen. Grundsätzlich ist es möglich das erste Substrat, das zumeist als Halbleitermaterial ausgebildet ist, gezielt einem Ätzvorgang zu unterziehen, wodurch es einerseits vom zweiten Substrat getrennt wird, andererseits aber unwiederbringbar zerstört wird. Dies jedoch ist aus Kostengründen nicht besonders anstrebenswert.

Sieht man hingegen eine die Struktur des ersten Substrates erhaltende Trennschicht zwischen dem ersten und dem zweiten Substrat vor, so kann das strukturierte Halbleitersubstrat auch unbeschadet und für weitere, anschließende, formgebende Prozesse wiederverwendet werden. Durch Aufbringen einer geeigneten Trennschicht kann vermieden werden, daß das vorzugsweise als Siliziumwafer ausgebildete erste Substrat beim abschließenden Entfernen zerstört werden muß. Dazu sind mehrere Vorgehensweisen möglich:

a) Auf dem Si-Wafer wird eine Kohlenstoffschicht (auch Diamant oder Diamantähnliche, SiC) aufgebracht, die ein Ankleben des glasartigen Materials des zweiten Substrates, das vorzugsweise als Glaswafer ausgebildet ist, am Siliziumwafer unterbindet. Die Verbindung des Si-Wafers mit dem Glaswafer wird vorzugsweise durch einen Ring aus einem Lot erreicht, der die beiden Wafer am Waferrand vakuumdicht verbindet. Zwar wird das Lot bei der Prozesstemperatur während des Temperns, bei der das Glasfließen stattfindet flüssig, die schlechte Benetzung der unbeschichteten Glas bzw. Kohlenstoffschichten verhindert jedoch, daß das Lot zu weit zwischen die Wafer eindringen kann.

Die Trennung der beiden Wafer kann entweder mechanisch erfolgen oder der Lotring kann durch Ätzen entfernt werden und die Kohlenstoffschicht durch einen Oxidationsprozess (ca. 400 - 500°C unter Sauerstoff).

Vor einen weiteren Einsatz des Siliziumwafers müssen unter Umständen diese Trennschicht erneut aufgetragen werden.

b) Auf dem Si-Wafer wird eine Haftvermittlungsschicht aus einem geeigneten Metall aufgebracht z. B. Tantal. Auf dieser Schicht wird ein weiteres Metall aufgebracht, z.B. Zinn. Zinn verhindert ebenfalls ein Ankleben des Glases am Silizium. Die Trennung der beiden Wafer kann durch Erhitzen des Zinns mechanisch erfolgen oder durch Herausätzen der Metallschicht.

c) Auf dem Siliziumwafer wird eine zweite Schicht aufgebracht, auf die direkt der Glaswafer anodisch gebondet werden kann. Beispiele hierfür wären Silizium, oder Titan. Am Ende des gesamten Prozesses wird diese Opferschicht durch Ätzen entfernt. Um zu verhindern, dass der ursprüngliche Si-Wafer angegriffen wird, kann der Si-Wafer mit geeigneten Schichten versehen werden z.B.: Siliziumnitrid, Siliziumcarbid.

Die Abformung von strukturierten Substratoberflächen, z. B. Siliziumscheibenoberflächen, in Glas stellt ein wichtiges und zukunftsträchtiges Verfahren für die Herstellung von z. B. mikrooptischen Bauelementen dar. Es werden unter Ausnutzung der Oberflächentopographie von einer Masterstruktur, bevorzugt aus Silizium, welche unter Einbeziehung der Vorteile der Halbleitertechnologie hergestellt wird, Strukturen bis in den sub-µm-Bereich auf glasartige Materialien exakt übertragen. Die vorteilhaften optischen, mechanischen und chemischen Eigenschaften z.B. von Glas können so den exakten Formgebungsverfahren und den vielfältigen Strukturierungsmöglichkeiten und -prozessen der Halbleitertechnologie zugänglich gemacht werden. Ein weiterer Vorteil ergibt sich aus der Tatsache, dass die Negativform nach Formgebung des Glases durch einen das Glas mechanisch nicht belastenden Ätzprozess entfernt wird. Dadurch lassen sich sehr tiefe Strukturen im Glas realisieren, wie dies aufgrund der mechanischen Belastung beim Prägen nie erreicht werden kann.

Das Verfahren besteht aus einer Kombination von Verfahrensschritten welche durch die Massenanwendung innerhalb der Halbleitertechnologie durch parallele Fertigung (Batch-Verfahren) besonders kostengünstig, effizient und mit einem hohen Reinheitsund Genauigkeitsgrad angewendet werden. Dadurch übertragen sich diese Vorteile auf das erfindungsgemäße Verfahren.

## Kurze Beschreibung der Zeichnungen

Die vorliegende Erfindung wird ohne Beschränkung des allgemeinen Erfindungsgedankens im Folgenden anhand von Ausführungsbeispielen unter Bezugnahme auf die Zeichnungen detailliert beschrieben.

Fig. 1    schematische Prozessfolge zur Abformung einer in einem Halbleitersubstrat prozessierten strukturierten Oberfläche auf ein Glasartiges Material,

Fig. 2    schematische Prozessvariante, bei der durch teilweises Hineinfließen des Glasmaterials in auf einem Halbleitersubstrat vorbereitete Vertiefungen beispielsweise ein Linsensystem hergestellt wird,

Fig. 3    Prozessvariante zur Herstellung eines mikromechanischen Bauelements

Fig.4    Beispiel für ein nach dem Erfindungsgemäßen Verfahren hergestellten mikromechanischen elektrostatischen Aktuator,

Fig. 5    Prozessvariante zur Herstellung eines zweiseitig mikrostrukturierten Glassubstrats und

Fig. 6    Prozessvariante zur Herstellung von Mikrozerstreuungslinsen.

## Darstellung zu Wegen von Ausführungsbeispielen

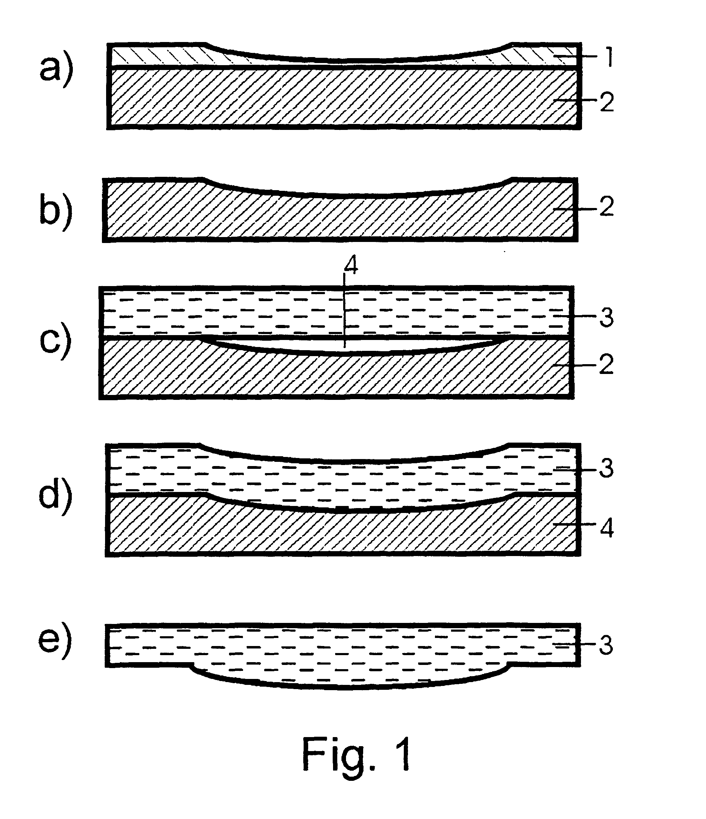

In Fig. 1 sind verschiedene Herstellungsstufen einer mikrostrukturierten Glasoberfläche unter Anwendung des erfindungsgemäßen Verfahrens zur Abbildung einer strukturierten Siliziumoberfläche dargestellt.

Es handelt sich um Herstellungsstufen nach Abschluss der folgenden Verfahrensschritte:

a) Strukturerzeugung im Photolack (1)
b) Strukturübertragung durch ätzen des Lacks und der Oberfläche des Siliziumwafers (2)
c) Anodisches Bonden eines Pyrex®-Glaswafers (3) auf die Siliziumoberflächenstrukturen mit Vertiefungen (4), bevorzugt unter vakuumähnlichen Bedingungen.
d) Tempern und Hineinfließen des Glases in die Siliziumoberflächenstrukturen unter Überdruckeinwirkung und/oder bedingt durch den Druckunterschied zwischen der Ofenatmosphäre und der in den Siliziumoberflächenvertiefungen konservierten Druckverhältnisse beim anodischen Bonden
e) Schleifen und Polieren der vom Silizium abgewandten Oberfläche des Glases nach Erkalten und darauffolgendes Wegätzen des Siliziums in z.B. Tetramethylammoniumhydroxid.

Um die beim Fliessprozess entstehenden Unebenheiten der Glaswafer-Rückseite gar nicht erst entstehen zu lassen, kann alternativ nach dem Bonden des Glaswafers mit dem strukturierten Siliziumwafer ein zweiter, planarer Siliziumwafer auf die Rückseite des Glaswafer durch einen zweiten anodischen Bondprozess aufgebracht werden.

Da Silizium eine hohe thermische Stabilität aufweist und die Glaswaferrückseite beim anodischen Bonden chemisch mit dem Rückseiten-Siliziumwafer verbunden wird, wirkt sich dieser Verbund beim anschließenden Fliessprozess homogenisierend auf die Rückseite aus. Die Rückseite bleibt somit planar. Beim Entfernen des Vorderseiten-Siliziumwafer kann dann gleichzeitig der Rückseiten-Siliziumwafer entfernt werden.

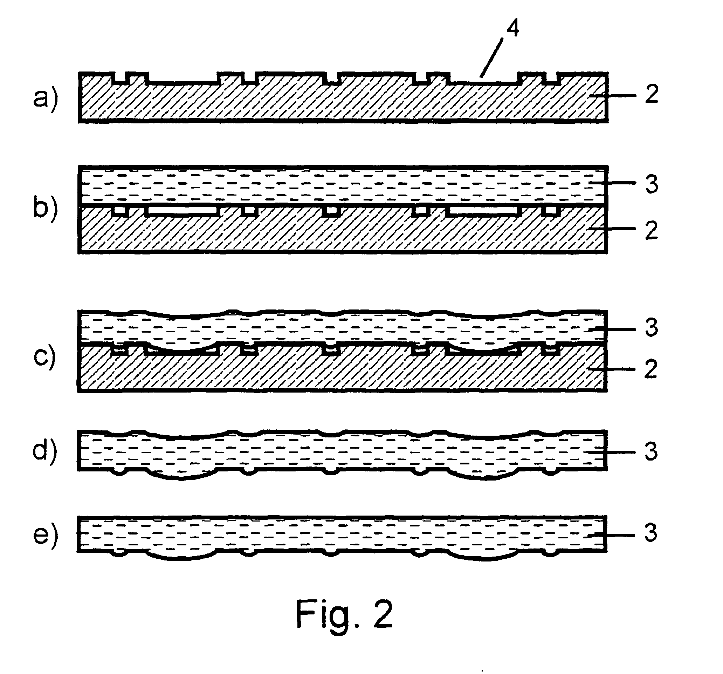

In Fig. 2 sind verschiedene Herstellungsstufen einer mikrostrukturierten Glasoberfläche unter Anwendung einer Abwandlung des erfindungsgemäßen Verfahrens, der Erzeugung eines Mikrolinsenarrays in Glas dargestellt. Es handelt sich um Herstellungsstufen nach Abschluss der folgenden Verfahrensschritte:

a) Strukturierung der Oberfläche des Siliziumwafers (2) mit Vertiefungen
b) Anodisches Bonden eines Pyrex®-Glaswafers (3) auf die Siliziumoberflächenstrukturen mit Vertiefungen (4), bevorzugt unter vakuumähnlichen Bedingungen
c) Tempern und teilweises Hineinfließen des Glases in die Siliziumoberflächenstrukturen, ohne Berührung des Bodens der Vertiefungen im Silizium
d) Entfernen des Siliziumwafers bevorzugt durch Ätzen
e) Abschleifen und/oder polieren der vom Silizium abgewandten Oberfläche des Glas-Wafers.

Die Prozessschritte d) und e) können dabei auch in umgekehrter Reihenfolge angewandt werden.

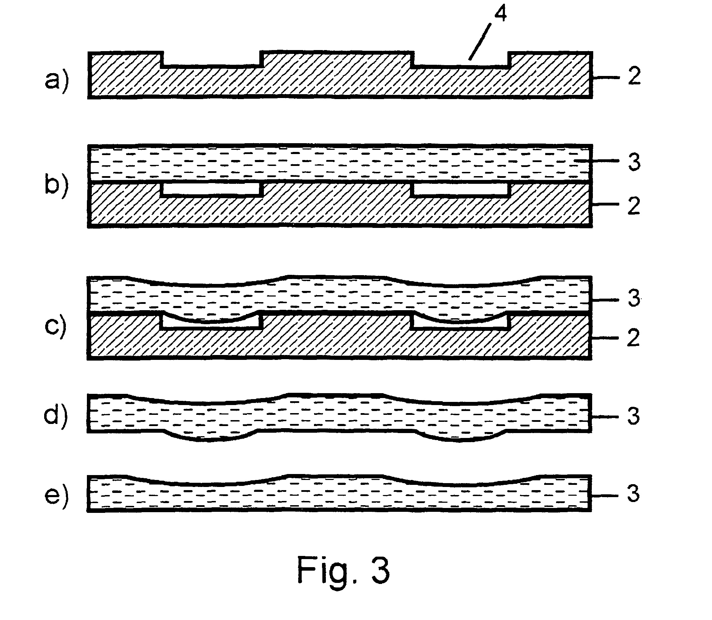

In Fig. 3 sind verschiedene Herstellungsstufen einer mikrostrukturierten Glasoberfläche unter Anwendung einer weiteren Abwandlung des erfindungsgemäßen Verfahrens, wie es bevorzugt zur Herstellung von Mikromechanischen Bauteilen eingesetzt wird, dargestellt. Es handelt sich um Herstellungsstufen nach Abschluss der folgenden Verfahrensschritte:

a) Strukturierung der Oberfläche des Siliziumwafers (2) mit Vertiefungen
b) Anodisches Bonden eines geeigneten Glases wie z.B. Pyrex®-Glaswafers (3) auf die Siliziumoberflächenstrukturen mit Vertiefungen (4), bevorzugt unter vakuumähnlichen Bedingungen
c) Tempern und teilweises Hineinfließen des Glases in die Siliziumoberflächenstrukturen, ohne Berührung der Wände der Vertiefungen im Silizium
d) Entfernen des Siliziumwafers bevorzugt durch ätzen
e) Abschleifen und/oder polieren der Oberfläche des Glas-Wafers welche mit dem Siliziumwafer verbunden war.

Die Prozessschritte d) und e) können dabei auch in umgekehrter Reihenfolge angewandt werden oder es kann ganz auf sie verzichtet werden.

Zum Erhalt der sich an der dem Si-Wafer (2) abgewandten Oberseite des Glaswafers (3) im Wege des Tempervorganges ausbildenden konkaven Einbuchtungen, die wie im weiteren ausgeführt wird, für interessante technische Anwendungen dienen, sollte die strukturierte Oberfläche des Si-Wafers (2) Vertiefungen mit Strukturbreiten B und das der Glaswafer (3) eine Dicke D aufweisen für die gilt:

$$B \geq 0{,}1 \cdot D$$

Auf diese Weise ist sichergestellt, dass sich der Materialfluss in die Vertiefungen auch in entsprechend gewünschter Weise auf der gegenüberliegenden Seite des Glaswafers (3) auswirkt und zu den konkaven Einbuchtungen führt.

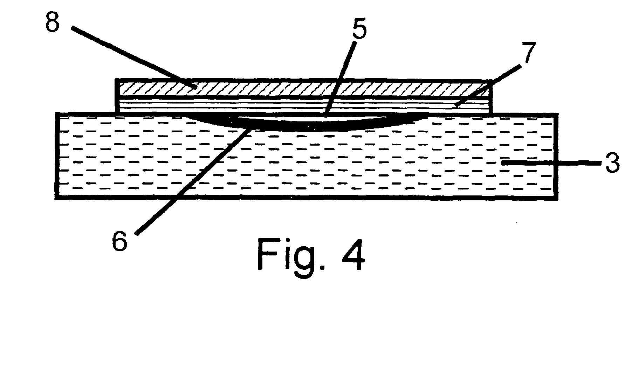

In Fig. 4 ist ein mikromechanischer elektrostatischer Aktuator im Querschnitt dargestellt, wie er beispielsweise als Mikroventil oder Mikrorelais zum Einsatz kommt und nach dem erfindungsgemäßen Verfahren hergestellt wird. Dazu wird die Prozessfolge, wie sie in Fig.3 dargestellt ist eingesetzt. Der elektrostatische Aktuator besteht aus einem Glassubstrat (3) mit einer erfindungsgemäß hergestellten Vertiefung (4). Mit einem Standardverfahren der Halbleitertechnologie werden bevorzugt metallische gekrümmte Elektroden (6) in den Vertiefungen als Schicht aufgebracht. Daraufhin wird eine elektrisch leitfähige elastische Membran (Aktor) über die Vertiefungen mit den Elektroden gespannt.

Dies kann durch Anodisches Bonden eines Siliziumwafers oder eines Silicon On Isolator (SOI) Wafers auf das Glassubstrat und darauffolgendes Dünnen des Wafers auf eine Dicke von wenigen Mikrometern geschehen. Die Membran besteht dann aus einer gegen die Elektroden mit einer Isolatorschicht (7) isolierten Siliziumschicht (8). Legt man eine Spannung zwischen der Siliziumschicht und den Elektroden an, so wird die Membran an die Elektrode gezogen und das Mikroventil /Mikrorelais geschaltet.

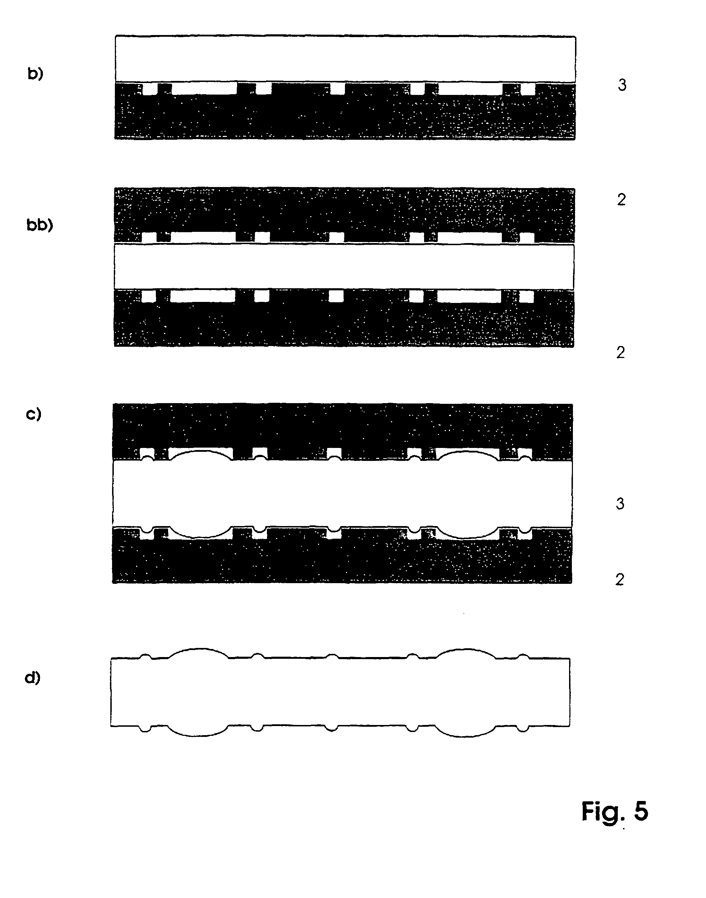

In Figur 5 sind Prozeßschritte zur Herstellung eines zweiseitig strukturierten Glassubstrates dargestellt. Im Schritt b) wird auf den strukturierten Si-Wafer (2) ein Glaswafer (3) aufgebracht. Im Schritt bb) wird ein weiterer strukturierter Si-Wafer (2) auf den Glaswafer (3) aufgebracht. Wie auch in den vorstehenden Prozessen erfolgt die innige Verbindung zwischen dem Si-Wafer (2) und den Glaswafern (3) vorzugsweise mittels anodischen Bonden. Sorgt man dafür, dass in den Zwischenräume ein Unterdruck herrscht, so fliesst das Glasmaterial des Glaswafers (3) beidseitig während des Tempervorganges (c) in die Vertiefungen des Si-Wafers (3). Nach entsprechender Entfernung der Si-Waferschichten (2), bspw. mittels Ätzen, vom Glaswafer (3) erhält man das gewünschte zweiseitig mikrostrukturierte Bauteil, das weiteren Verarbeitungsschritten zur Verfügung steht.

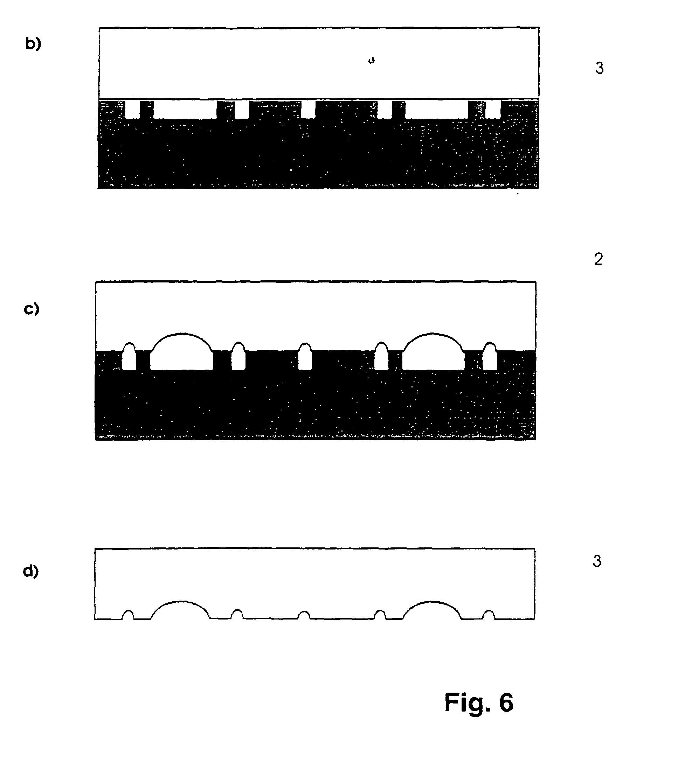

In Figur 6 ist die Herstellung eines mit Einbuchtungen versehenen Glassubstrat (3) dargestellt. Im Schritt b) wird auf den strukturierten Si-Wafer (2) ein Glaswafer (3) aufgebracht. Wie auch in den vorstehenden Prozessen erfolgt die innige Verbindung zwischen dem Si-Wafer (2) und den Glaswafern (3) vorzugsweise mittels anodischen Bonden. Von besondere Bedeutung ist im Falle der Figur 6, dass vor dem innigen Verbinden der Wafer in die eingeschlossenen Zwischenräume ein Medium, vorzugsweise ein gasförmiges Medium eingebracht wird, das sich bei Erwärmung ausdehnt. So wird beim anodischen Bonden der beiden Wafer ein Gas mit einem Partialdruck eingeschlossen, bspw. Luft oder Stickstoff. Übersteigt der Partialdruck innerhalb der Zwischenräume beim anschließendem Fliessprozess unter erhöhten Temperaturen den umgebenden Atmosphärendruck, so senkt sich die Glasoberfläche nicht in die freigeätzten Waferflächen hinein, sondern wird von dieser regelrecht weggedrückt. Es entstehen Eindrücke im Glaswafer. Die Tiefe dieser Eindrücke ist abhängig von dem ursprünglichen Bonddruck, dem Atmosphärendruck, der Prozesstemperatur sowie der Glastemperatur $T_G$ des Glaswafers. Die entstehenden Strukturen können zum Beispiel als Zerstreuungslinsen Verwendung finden.

Denkbar ist folglich auch eine Kombination von den in den Figuren 5 und 6 beschriebenen Prozessen. Somit könnten Linsen hergestellt werden, die konkave und konvexe Flächen besitzen.

<u>Bezugszeichenliste</u>

1   Photolack
2   Siliziumwafer, im Allgemeinen erstes Substrat
3   Glassubstrat
4   Oberflächenstruktur des ersten Substrats, mit Vertiefungen
5   Vertiefung
6   metallische gekrümmte Elektrode
7   Isolatorschicht
8   Siliziumschicht

**Patentansprüche**

1.  Verfahren zur Strukturierung von Oberflächen mikromechanischer und/oder mikrooptischer Bauteile und/oder Funktionselemente aus glasartigen Materialien, unter Verwendung folgender Verfahrensschritte:

    -   Bereitstellen eines ersten Substrats (2),
    -   Strukturierung mindestens einer Oberfläche des ersten Substrates zum Erhalt von Vertiefungen (4) auf der Oberfläche,
    -   Bereitstellen eines zweiten Substrates aus glasartigem Material (3),
    -   Verbinden des ersten Substrats mit dem zweiten Substrat aus glasartigem Material, wobei die strukturierte Oberfläche des ersten Substrats mit einer Oberfläche des glasartigen zweiten Substrats mindestens teilweise überdeckend zusammengeführt wird,
    -   Tempern der verbundenen Substrate derart, dass ein Hineinfließen des glasartigen Materials in die Vertiefungen der strukturierten Oberfläche des ersten Substrates erfolgt und dadurch die dem ersten Substrat zugewandte Seite des zweiten Substrats strukturiert wird und
    -   Abtrennen des zweiten Substrats vom ersten Substrat.

2.  Verfahren zur Strukturierung von Oberflächen mikromechanischer und/oder mikrooptischer Bauteile und/oder Funktionselemente aus glasartigen Materialien, unter Verwendung folgender Verfahrensschritte:

    -   Bereitstellen eines ersten Substrats (2),
    -   Strukturierung mindestens einer Oberfläche des ersten Substrates zum Erhalt von Vertiefungen (4) auf der Oberfläche,
    -   Bereitstellen eines zweiten Substrates aus glasartigem Material (3),
    -   Verbinden des ersten Substrats mit dem zweiten Substrat aus glasartigem Material, wobei die strukturierte Oberfläche des ersten Substrats mit einer Oberfläche des glasartigen zweiten Substrats mindestens teilweise überdeckend zusammengeführt wird,

- Tempern der verbundenen Substrate derart, dass ein Hineinfließen des glasartigen Materials in die Vertiefungen der strukturierten Oberfläche des ersten Substrates erfolgt und dadurch die dem ersten Substrat abgewandte Seite des zweiten Substrats strukturiert wird.

3. Verfahren zur Strukturierung von Oberflächen mikromechanischer und/oder mikrooptischer Bauteile und/oder Funktionselemente aus glasartigen Materialien, unter Verwendung folgender Verfahrensschritte:

- Bereitstellen eines ersten Substrats (2),
- Strukturierung mindestens einer Oberfläche des ersten Substrates zum Erhalt von Vertiefungen (4) auf der Oberfläche,
- Bereitstellen eines zweiten Substrates aus glasartigem Material (3),
- Verbinden des ersten Substrats mit dem zweiten Substrat aus glasartigem Material, wobei die strukturierte Oberfläche des ersten Substrats mit einer Oberfläche des glasartigen zweiten Substrats mindestens teilweise überdeckend zusammengeführt wird und wobei ein gasförmiges Medium in die Vertiefungen eingebracht wird, das sich bei Erwärmung ausdehnt,
- Tempern der verbundenen Substrate derart, dass durch Ausdehnen des gasförmigen Mediums innerhalb der Vertiefungen des ersten Substrats eine lokale Verdrängung des glasartigen Materials erfolgt, wodurch die dem ersten Substrat zugewandte Seite des zweiten Substrats strukturiert wird, und
- Abtrennen des zweiten Substrats vom ersten Substrat.

4. Verfahren nach Anspruch 2,
   **dadurch gekennzeichnet, dass** das zweite Substrat (3) vom ersten Substrat (2) getrennt wird.

5. Verfahren nach Anspruch 1, 3 oder 4,
   **dadurch gekennzeichnet, dass** das Abtrennen des zweiten Substrats (3) vom ersten Substrat (2) durch Wegätzen des ersten Substrates erfolgt.

6. Verfahren nach einem der Ansprüche 1, 3 bis 5,
   **dadurch gekennzeichnet, dass** das Abtrennen des zweiten Substrates (3) vom ersten Substrat (2) durch Vorsehen einer Trennschicht zwischen dem ersten und zweiten Substrat erfolgt, die vor dem Zusammenführen beider Substrate auf der strukturierten Oberfläche strukturerhaltend aufgebracht wird und als Opferschicht ausgebildet ist, die im Wege thermischer und/oder chemischer Einwirkung zerstört wird und ein Trennen beider Substrate voneinander ermöglicht.

7. Verfahren nach Anspruch 6,
   **dadurch gekennzeichnet, dass** als Trennschicht eine Metallschicht eingesetzt wird, die einen Schmelzpunkt aufweist, der unterhalb der Schmelzpunkte der Substrate (2, 3) liegt.

8. Verfahren nach Anspruch 6,
   **dadurch gekennzeichnet, dass** als Trennschicht eine oxidationsfähige Schicht eingesetzt wird, die sich unter Zufuhr von Sauerstoff und/oder thermischer Energie chemisch umwandelt.

9. Verfahren nach Anspruch 6,
   **dadurch gekennzeichnet, dass** als Trennschicht eine Kohlenstoffschicht, Diamantschicht, diamantähnliche Schicht oder SiC eingesetzt wird.

10. Verfahren nach einem der Ansprüche 1 bis 9,
    **dadurch gekennzeichnet, dass** die strukturierte Oberfläche des ersten Substrates (2) Vertiefungen (4) mit Strukturbreiten B und das zweite Substrat (3) eine Dicke D aufweist und dass in etwa gilt:

$$B \geq 0,1 \cdot D$$

11. Verfahren nach einem der Ansprüche 1 bis 10,
    **dadurch gekennzeichnet, dass** es sich bei dem ersten Substrat (2) um ein Halbleitersubstrat und/oder, dass es sich bei dem glasartigen Material um ein Bor-Silikat-Glas handelt.

12. Verfahren nach Anspruch 10,
    **dadurch gekennzeichnet, dass** es sich bei dem Halbleitersubstrat um ein Siliziumsubstrat und/oder, dass es sich bei dem Bor-Silikat-Glas um Pyrex®-Glas handelt.

13. Verfahren nach einem der Ansprüche 1 bis 12,
    **dadurch gekennzeichnet, dass** die Verbindung des ersten Substrats (2) mit dem zweiten Substrat (3) aus glasartigem Material durch anodisches Bonden erfolgt.

14. Verfahren nach einem der Ansprüche 1, 2 oder 4 bis 13,
    **dadurch gekennzeichnet, dass** ein während des Verbindungsprozesses herrschender Unterdruck, nach der Verbindung, in den Vertiefungen (4) der Oberfläche des ersten Substrats (2), zwischen erstem Substrat und dem zweiten Substrat (3) aus glasartigem Material konserviert wird.

**15.** Verfahren nach einem der Ansprüche 1 bis 13, **dadurch gekennzeichnet, dass** während des Temperns ein Überdruck auf die vom ersten Substrat (2) abgewandte Oberfläche des zweiten Substrates (3) aus glasartigem Material einwirkt.

**16.** Verfahren nach einem der Ansprüche 1, 2 oder 4 bis 15, **dadurch gekennzeichnet, dass** der Temperprozess durch Steuerung der Temperatur und der Dauer derart ausgeführt wird, dass das Hineinfließen des glasartigen Materials in die Vertiefungen (4) des ersten Substrats (2) bei einer gewünschten Einfließtiefe gestoppt wird, ohne dass das eingeflossene glasartige Material den Boden der Vertiefungen berührt.

**17.** Verfahren nach Anspruch 15 oder 16, **dadurch gekennzeichnet, dass** der Druck während und/oder die Temperatur und/oder die Dauer des Temperprozesses derart gewählt werden, dass eine Abformung der strukturierten Oberfläche des ersten Substrats (2) auf der Oberfläche des zweiten Substrats (3) aus glasartigem Material vorgenommen wird.

**18.** Verfahren nach mindestens einem der Ansprüche 1 bis 17, **dadurch gekennzeichnet, dass** nach dem Tempern oder nach dem Wegätzen des ersten Substrates (2) eine Oberfläche des Glassubstrates durch Schleifen und/oder Polieren planiert wird.

**19.** Verfahren nach einem der Ansprüche 1, 3 bis 18, **dadurch gekennzeichnet, dass** vor dem Tempervorgang auf einer dem ersten Substrat (2) abgewandten Seite des zweiten Substrats (3) ein drittes Substrat plan aufgebracht wird.

**20.** Verfahren nach Anspruch 19, **dadurch gekennzeichnet, dass** das dritte Substrat ein Halbleitersubstrat ist, vorzugsweise in Form eines Siliziumsubstrats.

**21.** Verfahren nach Anspruch 19 oder 20, **dadurch gekennzeichnet, dass** nach dem Tempervorgang das dritte Substrat mittels Ätzverfahren entfernt wird und eine plane Oberfläche an der dem ersten Substrat (2) abgewandten Seite des zweiten Substrats (3) entsteht.

**22.** Mikromechanisches Bauteil, das nach dem Verfahren nach einem der Ansprüche 2, 4 bis 16 herstellbar ist, **dadurch gekennzeichnet, dass** in den, auf der vom ersten Substrat (2) abgewandten Seite, während des Temperns entstandenen Vertiefungen (5) im zweiten Substrat (3) aus glasartigem Material Elektroden (6) angeordnet und die Vertiefungen mit einer elektrisch leitfähigen elastischen Membran (7,8) überspannt sind.

**23.** Verwendung des mikromechanischen Bauteils nach Anspruch 22 als mikromechanisches Ventil oder Relais.


**Claims**

**1.** Method of structuring surfaces of micro-mechanical and/or micro-optical components and/or functional elements consisting of glass-type materials, with application of the following steps of operation:

- providing a first substrate (2),
- structuring at least one surface of said first substrate in order to obtain recesses (4) on the surface,
- providing a second substrate of glass-type material (3),
- joining said first substrate to said second substrate of glass-type material, with the structured surface of said first substrate being joined to a surface of said glass-type second substrate in an at least partly overlapping relationship,
- annealing the substrates so joined in such a way that said glass-type material will flow into the recesses of said structured surface of said first substrate, structuring hence that side of said second substrate, which faces said first substrate, and
- separating said second substrate from said first substrate.

**2.** Method of structuring surfaces of micro-mechanical and/or micro-optical components and/or functional elements consisting of glass-type materials, with application of the following steps of operation:

- providing a first substrate (2),
- structuring at least one surface of said first substrate in order to obtain recesses (4) on the surface,
- providing a second substrate of glass-type material (3),
- joining said first substrate to said second substrate of glass-type material, with the structured surface of said first substrate being joined to a surface of said glass-type second substrate in an at least partly overlapping relationship,
- annealing the substrates so joined in such a way that said glass-type material will flow into the recesses of said structured surface of said first substrate, structuring hence that side of said second substrate, which is turned away from said first substrate.

3. Method of structuring surfaces of micro-mechanical and/or micro-optical components and/or functional elements consisting of glass-type materials, with application of the following steps of operation:

- providing a first substrate (2),
- structuring at least one surface of said first substrate in order to obtain recesses (4) on the surface,
- providing a second substrate of glass-type material (3),
- joining said first substrate to said second substrate of glass-type material, with the structured surface of said first substrate being joined to a surface of said glass-type second substrate in an at least partly overlapping relationship and with a gaseous medium being introduced into said recesses, which expands when heated,
- annealing the substrates so joined in such a way that due to the expansion of said gaseous medium within said recesses in said first substrate a local displacement of said glass-type material takes place, so that the side of said second substrate will be structured, which faces said first substrate, and
- separating said second substrate from said first substrate.

4. Method according to Claim 2, **characterised in that** said second substrate (3) is separated from said first substrate (2).

5. Method according to Claim 1, 3 or 4, **characterised in that** the separation of said second substrate (3) from said first substrate (2) is realised by removal of said first substrate by etching.

6. Method according to any of the Claims 1, 3 to 5, **characterised in that** the separation of said second substrate (3) from said first substrate (2) is realised by providing a parting layer between said first and second substrates, which is applied on said structured surface while maintaining the structure prior to joining both substrates and which is configured as sacrificial layer that will be destroyed by thermal and/or chemical action and permits a separation of both substrates from each other.

7. Method according to Claim 6, **characterised in that** a metal layer is employed as parting layer, whose melting point is below the melting points of said substrates (2, 3).

8. Method according to Claim 6, **characterised in that** an oxidisable layer is used as parting layer, which undergoes a chemical reaction when oxygen and/or thermal energy is supplied.

9. Method according to Claim 6, **characterised in that** a carbon layer, a diamond layer, a diamond-type layer or SiC is used as parting layer.

10. Method according to any of the Claims 1 to 9, **characterised in that** the structured surface of said first substrate (2) presents recesses (4) having structural widths B while said second substrate (3) presents a thickness D, and that the following approximate relationship applies:

$$B \geq 0.1 \cdot D$$

11. Method according to any of The Claims 1 to 10, **characterised in that** said first substrate (3) is a semiconductor substrate and/or that said glass-type material is a borosilicate glass.

12. Method according to Claim 10, **characterised in that** said semiconductor substrate is a silicon substrate and/or that said borosilicate glass is Pyrex® glass.

13. Method according to any of the Claims 1 to 12, **characterised in that** the step of joining said first substrate (2) to said second substrate (3) of glass-type material is carried out by anodic bonding.

14. Method according to any of the Claims 1, 2 or 4 to 13, **characterised in that** a negative pressure prevailing throughout the joining process is preserved, after joining, in the recesses (4) of the surface of said first substrate (2), between said first substrate and said second substrate (3) of glass-type material.

15. Method according to any of the Claims 1 to 13, **characterised in that** an overpressure acts upon the surface of said second substrate (3) of glass-type material, which is turned away from said first substrate (2), throughout the annealing process.

16. Method according to any of the Claims 1, 2 or 4 to 15, **characterised in that** the annealing process is carried out by controlling the temperature and the period in such a way that the inflow of said glass-type material into the recesses (4) of said first substrate (2) is stopped at a desired depth of inflow, without the in-flown glass-type material contacting the bottom of said recesses.

17. Method according to Claim 15 or 16, **characterised in that** the pressure during and/or the temperature and/or the period of the annealing process are so selected that a relief moulding of the structured surface of said first substrate (2) will be created on the surface of said second substrate (3) of glass-type material.

18. Method according to at least one of the Claims 1 to 17,
**characterised in that** one surface of said glass substrate is planished by grinding and/or polishing after annealing or after removal of said first substrate (2) by etching.

19. Method according to any of the Claims 1, 3 to 18,
**characterised in that** prior to the annealing process, a third substrate is evenly applied on a side of said second substrate (3), which is turned away from said first substrate (2).

20. Method according to Claim 19,
**characterised in that** said third substrate is a semiconductor substrate, preferably in the form of a silicon substrate.

21. Method according to Claim 19 or 20,
**characterised in that** said third substrate is removed by an etching operation after the annealing process and that a planar surface is created on that side of said second substrate (3), which is turned away from said first substrate (2).

22. Micro-mechanical component adapted to be manufactured in correspondence with any of the Claims 2, 4 to 16,
**characterised in that** electrodes (6) are arranged in the recesses (5) formed in the course of the annealing process in said second substrate (3) of glass-type material on that side, which is turned away from said first substrate (2), and that said recesses are spanned by an electrically conductive resilient membrane (7, 8).

23. Application of said micro-mechanical component according to Claim 22 as a micro-mechanical valve or relay.

## Revendications

1. Procédé à structurer des surfaces des composants micro mécaniques et/ou micro optiques et/ou des éléments fonctionnels constitués par des matériaux vitreux, en utilisant des étapes d'opération suivantes:

   - mise à disposition d'un premier substrat (2),
   - structurer au moins une surface dudit premier substrat afin d'achever des creux (4) dans la surface,
   - mise à disposition d'un deuxième substrat en matériau vitreux (3),
   - réunir ledit premier substrat avec ledit deuxième substrat en matériau vitreux, à la surface structurée dudit premier substrat étant réunie avec une surface dudit deuxième substrat vitreux à recouvrement, au moins en partie,
   - recuire les substrats ainsi liés d'une telle façon, que ledit matériau vitreux s'écoule dans les creux de ladite surface structurée dudit premier substrat, en structurant ainsi ce côté dudit deuxième substrat, qui se trouve en face dudit premier substrat, et
   - séparer ledit deuxième substrat dudit premier substrat.

2. Procédé à structurer des surfaces des composants micro mécaniques et/ou micro optiques et/ou des éléments fonctionnels constitués par des matériaux vitreux, en utilisant des étapes d'opération suivantes:

   - mise à disposition d'un premier substrat (2),
   - structurer au moins une surface dudit premier substrat afin d'achever des creux (4) dans la surface,
   - mise à disposition d'un deuxième substrat en matériau vitreux (3),
   - réunir ledit premier substrat avec ledit deuxième substrat en matériau vitreux, à la surface structurée dudit premier substrat étant réunie avec une surface dudit deuxième substrat vitreux à recouvrement, au moins en partie,
   - recuire les substrats ainsi liés d'une telle façon, que ledit matériau vitreux s'écoule dans les creux de ladite surface structurée dudit premier substrat, en structurant ainsi ce côté dudit deuxième substrat, qui est opposé audit premier substrat.

3. Procédé à structurer des surfaces des composants micro mécaniques et/ou micro optiques et/ou des éléments fonctionnels constitués par des matériaux vitreux, en utilisant des étapes d'opération suivantes:

   - mise à disposition d'un premier substrat (2),
   - structurer au moins une surface dudit premier substrat afin d'achever des creux (4) dans la surface,
   - mise à disposition d'un deuxième substrat en matériau vitreux (3),
   - réunir ledit premier substrat avec ledit deuxième substrat en matériau vitreux, à la surface structurée dudit premier substrat étant réunie avec une surface dudit deuxième substrat vitreux à recouvrement, au moins en partie, et en introduisant un milieu gazeux dans lesdits creux, qui se dilate quand il est chauffé,

- recuire les substrats ainsi liés d'une telle façon, que, grâce à la dilatation dudit milieu gazeux à l'intérieur desdits creux dans ledit premier substrat, il y a un déplacement local dudit matériau vitreux et ainsi ce côté dudit deuxième substrat est structuré, qui se trouve en face dudit premier substrat, et

- séparer ledit deuxième substrat dudit premier substrat.

**4.** Procédé selon la revendication 2,
**caractérisé en ce que** ledit deuxième substrat (3) est séparé dudit premier substrat (2).

**5.** Procédé selon la revendication 1, 3 ou 4,
**caractérisé en ce que** la séparation dudit deuxième substrat (3) dudit premier substrat (2) se fait par décapage à l'acide dudit premier substrat.

**6.** Procédé selon une quelconque des revendications 1, 3 à 5,
**caractérisé en ce que** la séparation dudit deuxième substrat (3) dudit premier substrat (2) se fait par l'arrangement d'une couche de séparation entre lesdits premier et deuxième substrats, qui est appliquée sur ladite surface structurée en retenant la structure avant la réunion les deux substrats, et qui est configurée en tant que couche consommable, qui est détruite par action thermique et/ou chimique, en permettant une séparation des deux substrats l'un de l'autre.

**7.** Procédé selon la revendication 6,
**caractérisé en ce qu'**une couche métallique est utilisée en tant que couche de séparation, dont le point de fusion est inférieur aux points de fusion desdits (2, 3).

**8.** Procédé selon la revendication 6,
**caractérisé en ce qu'**une couche oxydable est utilisée en tant que couche de séparation, qui subit une réaction chimique à l'alimentation d'oxygène et/ou de l'énergie thermique.

**9.** Procédé selon la revendication 6,
**caractérisé en ce qu'**une couche en carbone, une couche diamantée, une couche diamantine ou en SiC est utilisée en tant que couche de séparation.

**10.** Procédé selon une quelconque des revendications 1 à 9,
**caractérisé en ce que** la surface structurée dudit premier substrat (2) a des creux (4) aux largeurs structurelles B pendant que le deuxième substrat (3) a une épaisseur D, à la relation suivante s'appliquant environ :

$$B \geq 0.1 \cdot D$$

**11.** Procédé selon une quelconque des revendications 1 à 10,
**caractérisé en ce que** ledit premier substrat (3) est un substrat semi-conducteur et/ou **en ce que** ledit matériau vitreux est un verre au borosilicate.

**12.** Procédé selon la revendication 10,
**caractérisé en ce que** ledit substrat semi-conducteur est un substrat en silicium et/ou **en ce que** ledit verre au borosilicate est du verre Pyrex®.

**13.** Procédé selon une quelconque des revendications 1 à 12,
**caractérisé en ce que** l'opération de joindre ledit premier substrat (2) audit deuxième substrat (3) en matériau vitreux se fait par métallisation anodique.

**14.** Procédé selon une quelconque des revendications 1, 2 ou 4 à 13,
**caractérisé en ce qu'**une pression négative , qui règne au cours du tout processus de réunion, est retenu, suivant la réunion, dans les creux (4) dans la surface dudit premier substrat (2), entre ledit premier substrat et ledit deuxième substrat (3) en matériau vitreux.

**15.** Procédé selon une quelconque des revendications 1 à 13,
**caractérisé en ce qu'**une surpression agit sur la surface dudit deuxième substrat (3) en matériau vitreux, qui est opposée audit premier substrat (2), pendant tout le processus de recuite.

**16.** Procédé selon une quelconque des revendications 1, 2 ou 4 à 15,
**caractérisé en ce que** le processus de recuite se fait par réglage de la température et de la durée d'une telle façon, que l'entrée dudit matériau vitreux dans les creux (4) dudit premier substrat (2) s'arrête à une profondeur souhaitée d'écoulement, sans contact entre le matériau vitreux y entré avec le fond desdits creux.

**17.** Procédé selon la revendication 15 ou 16,
**caractérisé en ce que** la pression au cours et/ou la température et/ou la durée du processus de recuite sont choisis d'une manière à créer une copie moulée de la surface structurée dudit premier substrat (2) dans la surface dudit deuxième substrat (3) en matériau vitreux.

**18.** Procédé selon au moins une quelconque des revendications 1 à 17,
**caractérisé en ce qu'**une surface dudit substrat vitreux est aplanie par rectification et/ou polissage après la recuite ou après l'enlevage à l'acide dudit premier substrat (2).

19. Procédé selon une quelconque des revendications 1, 3 à 18,
**caractérisé en ce qu'**avant le processus de recuite, un troisième substrat est régulièrement déposée d'un côté dudit deuxième substrat (3), qui est opposé audit premier substrat (2).

20. Procédé selon la revendication 19,
**caractérisé en ce que** ledit troisième substrat est un substrat semi-conducteur, de préférence sous forme d'un substrat en silicium.

21. Procédé selon la revendication 19 ou 20,
**caractérisé en ce que** ledit troisième substrat est décapé à l'acide après le processus de recuite, et **en ce qu'**une surface planaire est créée de ce côté dudit deuxième substrat (3), qui est opposé audit premier substrat (2).

22. Composant micro mécanique apte à être fabriqué en correspondance avec une quelconque des revendications 2, 4 à 16,
**caractérisé en ce que** des électrodes (6) sont disposées dans les creux (5) formés au cours du processus de recuite dans ledit deuxième substrat (3) en matériau vitreux de ce côté, qui est opposé audit premier substrat (2), et **en ce que** lesdits creux sont couverts par une membrane élastique à condition électrique (7, 8).

23. Emploi du composant micro mécanique selon la revendication 22 en tant que soupape ou relais micro mécanique.

Fig. 1

a) — 4, 2

b) — 3, 2

c) — 3, 2

d) — 3

e) — 3

Fig. 2

Fig. 3

Fig. 4

b)

3

bb)

2

2

c)

3

2

d)

Fig. 5

**b)**

3

2

**c)**

**d)**

3

**Fig. 6**